# EUROPÄISCHE PATENTSCHRIFT

(11) **EP 1 844 180 B1**
(45) Veröffentlichungstag und Bekanntmachung des Hinweises auf die Patenterteilung: **31.05.2017**
(21) Anmeldenummer: 06707668.7
(22) Anmeldetag: 05.01.2006
(51) Int. Cl.: C23C 16/455

(54) **GASVERTEILER MIT IN EBENEN ANGEORDNETEN VORKAMMERN**
GAS DISTRIBUTOR WITH PRE-CHAMBERS ARRANGED IN PLANES
DISTRIBUTEUR DE GAZ MUNI DE PRECHAMBRES SITUEES DANS DES PLANS

(30) Priorität: 31.01.2005 DE 102005004312
(43) Veröffentlichungstag der Anmeldung: 17.10.2007
(73) Patentinhaber: Aixtron SE, 52134 Herzogenrath (DE)
(72) Erfinder: STRAUCH, Gerhard Karl, 52074 Aachen (DE); REINHOLD, Markus, 40721 Hilden (DE); BAUMANN, Peter, 52072 Aachen (DE)
(74) Vertreter: Grundmann, Dirk
(86) Internationale Anmeldenummer: PCT/EP2006/050049
(87) Internationale Veröffentlichungsnummer: WO 2006/082117

(56) Entgegenhaltungen:
- US-A- 5 453 124
- US-A1- 2004 149 212
- US-B1- 6 245 192

## Beschreibung

Die Erfindung betrifft einen Gasverteiler in einem CVD- oder OVPD-Reaktor mit zwei oder mehreren Gasvolumina, in die jeweils eine Zuleitung für ein Prozessgas mündet, wobei jedes Gasvolumen mit einer Vielzahl von im Boden (5) des Gasverteilers mündende Austrittsöffnungen für das jeweilige Prozessgas verbunden ist.

Ein gattungsgemäßer Gasverteiler ist aus der EP 0 687 749 A1 bekannt. Der Gasverteiler befindet sich in einem CVD-Reaktor und bildet die Decke einer Prozesskammer, deren Boden ein Substrathalter bildet, auf dem ein oder mehrere Substrate angeordnet werden, um beschichtet zu werden, wobei die die Schicht bildenden Materialien mittelst des Gasverteilers in die Prozesskammer eingeleitet werden. Der aus der EP 6 87 749 A1 oder aus US 5 453 124 A1 bekannte Gasverteiler besitzt mehrere übereinander angeordnete Gasvolumina, die jeweils mit einem anderen Prozessgas versorgt werden. Jedes der Gasvolumina besitzt Austrittskanäle, die im Boden des Gasverteilers münden. Die beiden Gasvolumina liegen übereinander und erstrecken sich über die gesamte Querschnittsfläche des Gasverteilers. Die Zuleitungen zu den Gasvolumina befinden sich am Rand, so dass das aus dem Gasverteiler heraustretende Gas Inhomogenitäten aufweisen kann. Gasverteiler der gattungsgemäßen Art werden bei der MOCVD eingesetzt. Metal Organic Chemical Vapor Deposition (MOCVD) ist eine weit verbreitete Methode zur Abscheidung von ein- oder mehrkomponentigen oxidischen Isolationsschichten (Dielektrika), Halbleiterschichten, Passivierungsschichten oder elektrisch leitenden Schichten. Dazu werden mehrere reaktive Gase bzw. gasförmige Precursoren gemischt, einer Reaktionskammer zugeführt, um eine Schicht auf einem beheizten Substrat abzuscheiden, und dann aus der Reaktionskammer abgepumpt. Bei den Reaktoren gibt es verschiedene geometrische Anordnungen, z.B. horizontale und vertikale Reaktoren. Bei horizontalen Reaktoren befindet sich die Substratoberfläche parallel zur Flussrichtung der gemischten Precursoren und reaktiven Gase. In vertikalen Reaktoren trifft das entsprechende Gasgemisch vertikal auf die Substratoberfläche und fließt zu den äußeren Rändern des Substrats ab, bevor es die Reaktionskammer verlässt. Generell kann eine Substratrotation zur Erhöhung der Gleichförmigkeit der abgeschiedenen Schicht eingesetzt werden.

Um eine homogene Abscheidung auf dem Substrat zu gewährleisten, muss eine gute Durchmischung der verschiedenen gasförmigen Precursoren bzw. reaktiven Gase gewährleistet sein. Um das zu erzielen gibt es Methoden, bei denen die Gasmischung früh vor dem Einleiten in die Reaktionskammer erreicht wird. Dies ist für Precursoren und reaktiven Gasen geeignet, die bei der Temperatur und Druck im Gasverteiler stabil sind.

Die verwendeten Precursoren sind aber oft sehr reaktiv und können dabei preliminäre Gasphasenreaktionen verursachen. Dies führt zu Abscheidung und damit fortschreitender Verunreinigung an gasführenden Teilen vor dem Substrat, verursacht Partikelbildung und damit Partikelbelegung des Substrats, verändert die Reaktionschemie beim Substrat, und reduziert die Effizienz des Wachstumsprozesses.

Beim oben genannten Mehrkammergasverteiler siehe auch US 5871586 werden die verschiedenen gasförmigen Komponenten in separaten Kammern herangeführt, und über eine Vielzahl von Öffnungen direkt dem Substrat zugeführt. Die Mischung erfolgt erst in dem Bereich direkt bei dem Substrat. Bei einem solchen Mehrkammer-Gasverteiler führen Durchführungsrohre von einer ersten Kammer bis in einen Gasverteilerauslass und durchqueren dabei mindestens eine andere Kammer. Dadurch ergeben sich in den Kammern enge Flussquerschnitte um die Durchführungsrohre. Dies führt zu inhomogenen Flüssen und erhöhtem Druckabfall innerhalb einer Kammer. Diese Probleme nehmen bei größeren Durchmessern des Gasverteilers zu, da sich die Zahl der Durchführungsrohre mit der Fläche erhöht. Außerdem wird die Fertigung des Gasverteilers mit zunehmender Zahl der Durchführungsrohres sehr viel komplizierter, da jedes Durchführungsrohr an jeder Trennwand einer Kammer gasdicht sein muss. Ein solcher Gasverteiler ist kaum skalierbar und ist daher praktisch nicht für die Beschichtung von größeren Substraten herstellbar bzw. benutzbar e.g. 200mm, 300mm. Ein solcher Gasverteiler lässt sich nach Herstellung praktisch nicht mehr z.B. für Wartungszwecke öffnen.

Bei einigen Prozessen für oxidische Isolationsschichten (Dielektrika), Passivierungsschichten oder elektrisch leitende Schichten hat sich gezeigt, dass diese Art der Durchmischung nicht zu hinreichend homogenen Schichten auf dem Substrat führt. Für einige Anwendungen sind die Anforderung für die Inhomogenität der abgeschiedenen Schichten auf der Substratoberfläche z.B. <+1%.

Viele gasförmige metallorganische Precursoren sind als solche nur in einem kleinen Temperaturfenster stabil. (Metallorganische Precursoren können mindestens ein Metallatom und/oder auch mindestens ein Halbleiter- / Halbmetallatom (wie z.B. Si, Ge) enthalten. Bei zu tiefen Temperaturen findet Kondensation statt, bei zu hohen Temperaturen Zersetzung, selbst vor Mischung mit anderen reaktiven Gasen. Daher ist eine homogene Temperierung des Gasverteilers notwendig.

Ausgehend vom gattungsgemäßen Stand der Technik liegt der Erfindung die Aufgabe zugrunde, die Wirkungsweise eines Gasverteilers zu verbessern.

Gelöst wird die Aufgabe durch die in den Ansprüchen angegebene Erfindung. Wobei jeder einzelne der Ansprüche grundsätzliche eigenständige Lösungswege darstellt und jeder Anspruch mit jedem Anspruch als eigenständige technische Lösung miteinander kombinierbar ist.

Der Anspruch 1 sieht zunächst und im Wesentlichen vor, dass die Gase in einer ersten Ebene in Radialrichtung und in einer zweiten, darunter liegenden Ebene sodann in Umfangsrichtung verteilt werden, bevor sie durch die Austrittsöffnungen am Boden des Gasverteilers letzteren verlassen. Andere Ansprüche sehen zunähst und im Wesentlichen vor, dass jedes Gasvolumen von mehreren Vorkammern gebildet ist, wobei die Vorkammern in einer gemeinsamen ersten Ebene liegen, und wobei in einer den Boden des Gasverteilers bildenden zweiten Ebene eine Vielzahl von jeweils Gasvolumen zugeordnete Gasverteilungskammern vorgesehen sind, wobei die Vorkammern und die Gasverteilungskammern jedes Gasvolumens mit Verbindungskanälen verbunden sind. Bevorzugt sind alle Vorkammern in einer gemeinsamen ersten Ebene angeordnet. In einer Weiterbildung der Erfindung ist vorgesehen, dass die Vorkammern, die einem Gasvolumen gehören, verschiedene Radialabstände zum Zentrum des Gasverteilers besitzen. Es ist auch vorgesehen, dass die zu einem Gasvolumen gehörenden Vorkammern in Umfangsrichtung verteilt angeordnet sind. Die Vorkammern zwei verschiedener Gasvolumina können kammartig ineinander greifen. Die Kammzinken können dabei in Radialrichtung verlaufende Fortsätze jeder einzelnen Kammer sein. Die Gasverteilungskammern können das Zentrum des Gasverteilers konzentrisch umgeben. Es ist vorgesehen, dass eine Gasverteilungskammer mit mehreren Vorkammern verbunden ist. Eine Vorkammer kann auch wiederum mit mehreren Gasverteilungskammern verbunden sein. Bevorzugt liegen die Verbindungskanäle zwischen den einzelnen Kammern in einer dritten Ebene, die sich zwischen erster und zweiter Ebene befindet. Erfindungsgemäß ist ein Mehrkammergasverteiler gegeben, wobei die gasförmigen Precursoren, die Metalle oder Halbleiter beinhalten können, und die reaktiven Gase separat in einen Gasverteiler eingeleitet werden. Der Gasverteiler weist ein hohes Maß an Temperaturhomogenität auf, um Kondensation, Zersetzung und preliminäre Reaktionen der Precursoren mit den chemisch reaktiven Gasen zu vermeiden. Dabei ist ein möglichst geringer Druckabfall beim Durchgang durch den Gasverteiler für die gasförmigen Precursoren vorteilhaft. Dies ist insbesondere dann der Fall, wenn dem Gasverteiler ein Verdampfer vorgeschaltet ist. Mit diesem Verdampfer können flüssige oder feste Ausgangsstoffe in Prozessgase verdampft werden. In einer bevorzugten Anordnung wird der Gasverteiler in einem CVD-Reaktor verwendet. Dabei erstreckt sich der Gasverteiler im Wesentlichen parallel zu einem Substrathalter. Substrathalter und Gasverteiler bilden dann die Begrenzungen einer Prozesskammer. Dabei kann sich der Gasverteiler oberhalb, unterhalb oder seitlich des Substrathalters befinden. Bevorzugt grenzt der Gasverteiler die Prozesskammer nach oben hin ab. Der Boden des Gasverteilers bildet dann die Decke einer Prozesskammer. Der Boden der Prozesskammer ist der Substrathalter. Auf dem Substrathalter können ein oder mehrere Substrate angeordnet werden. Der Gasverteiler hat insgesamt ein duschkopfartiges Aussehen. Aus den am Boden des Gasverteilers angeordneten Öffnungen treten die Prozessgase aus, um in der Gasphase oder aber auch auf dem Substrat miteinander zu reagieren, wobei auf dem Substrat eine Schicht abgeschieden wird. Die Massenflüsse der Gase können so eingestellt werden, dass die Gase im Gasverteiler eine Verweilzeit von 10ms bis 16ms haben. Dabei sind die einzelnen Kammern der Gasvolumina so gestaltet, dass dies für Gesamtgasflüsse von 300 bis 1200sccm gilt. Der Druckabfall beim Durchfließen des Gasverteilers liegt bevorzugt bei <2,5mbar, bei einem Gesamtfluss von 1200sccm. Die Temperaturinhomogenität entlang des Gasflussweges ist vorzugsweise geringer als 10%. Bei einem Austritt der gasförmigen Precursoren aus den Gasauslassöffnungen des Gasverteilers ergibt sich für die Flussverteilung eine Standard-Abweichung von 0,3% bis 0,9%. Als Trägergase für die Precursoren sind Stickstoff, Wasserstoff, Helium und Argon oder ein anderes Edelgas bzw. inertes Gas zu bevorzugen. In einer bevorzugten Ausgestaltung werden gasförmige Precursoren oder bei Raumtemperatur flüssige oder metallorganische Ausgangsstoffe verwendet. Diese werden in besonderen Verdampfungen in die Gasphase überführt und danach dem Gasverteiler zugeführt. Sie treten dort in das ihnen zugeordnete Gasvolumen ein. Der Gasstrom wird aufgespalten in mehrere Teilgasströme mit denen die einzelnen Vorkammern versorgt werden. Über die Vorkammern tritt das Prozessgas dann durch die Verbindungskanäle in die kreisförmig das Zentrum des Gasverteilers umgebende Gasverteilungskammer. Dabei treten Gase aus unterschiedlichen Vorkammern desselben Gasvolumens in ein und dieselbe Gasverteilungskammer. In ein zweites Gasvolumen wird ein reaktives Gas, beispielsweise O₂, O₃, NO₂, H₂O, NH₃ oder H₂ eingeleitet. Dieses Gasvolumen kann ein oder mehrere Vorkammern besitzen. Die Vorkammer bzw. die Vorkammern sind ebenfalls über Verbindungskanäle mit konzentrisch um das Zentrum des Gasverteilers angeordnete Gasverteilungskammern verbunden. Die zu den einzelnen Gasvolumina gehörenden Gasverteilungskammern können sich in Radialrichtung abwechseln. Mit der erfindungsgemäßen Vorrichtung werden mehrkomponentige, oxidische Isolationsschichten, Dielektrika, Passivierungsschichten, halbleitende Schichten oder elektrisch leitende Schichten oder Schichtenfolgen auf mindestens einem Substrat abgeschieden.

Ein Ausführungsbeispiel der Erfindung wird anhand der beigefügten Zeichnungen erläutert, es zeigen:
- Fig. 1: die Draufsicht auf einen Gasverteiler,
- Fig. 2: die Seitenansicht auf den Gasverteiler,
- Fig. 3: einen Schnitt gemäß der Linie III-III in Figur 1,
- Fig. 4: einen Schnitt gemäß der Linie IV-IV in Figur 1,
- Fig. 5: einen Schnitt gemäß der Linie V-V in Figur 2, wobei jeweils nur die Strukturen der unmittelbar darunter liegenden Ebene dargestellt sind,
- Fig. 6: einen Schnitt gemäß der Linie VI-VI in Figur 2, wobei nur die unmittelbar unterhalb der Schnittebene liegenden Strukturen sichtbar gemacht sind,
- Fig. 7: einen Schnitt gemäß der Linie VII-VII in Figur 2, wobei jeweils nur die unmittelbar unterhalb der Schnittebene liegenden Strukturen sichtbar gemacht sind,
- Fig. 8: einen Schnitt gemäß der Linie VIII-VIII in Figur 2, wobei jeweils die unmittelbar unterhalb der Schnittebene liegenden Strukturen sichtbar gemacht sind,

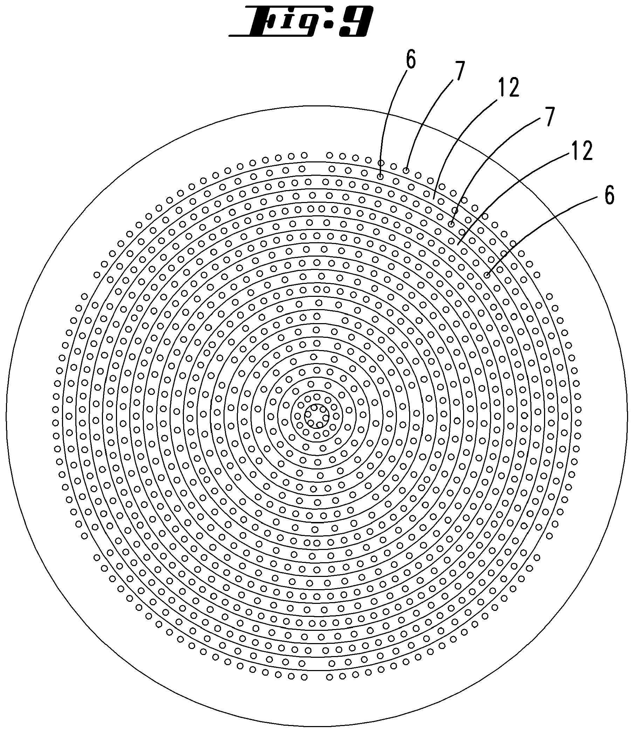

- Fig. 9: einen Schnitt gemäß der Linie IX-IX in Figur 2, wobei jeweils nur die unmittelbar unterhalb der Schnittebene liegenden Strukturen sichtbar gemacht sind und
- Fig. 10: in grob schematischer Darstellung einen CVD-Reaktor im Querschnitt mit einem in den vorangegangenen Figuren dargestellten Gasverteiler.

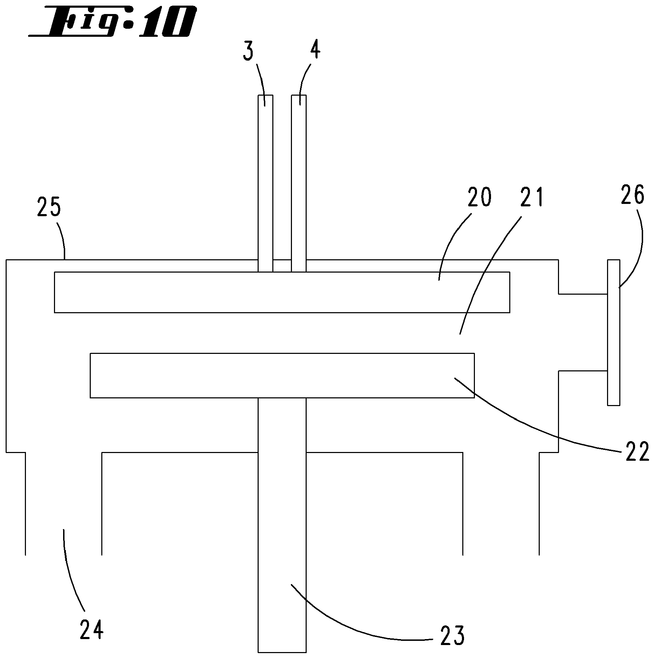

Die Figur 10 zeigt den prinzipiellen Aufbau eines CVD, insbesondere MOCVD-Reaktors. Dieser besitzt eine Reaktionskammer 25, die zur Außenwelt hin vakuumdicht ist. Die Reaktionskammer 25 besitzt eine Be-/Entladeöffnung 26, um in die Prozesskammer 21 ein oder mehrere Substrate einzubringen. Die Substrate liegen dabei auf einem von unten beheizbaren Suszeptor 22, der mittelst einer drehbaren Suszeptorhalterung 23 in der Reaktorkammer 25 gehalten ist. Die Reaktorkammer 25 weist darüber hinaus einen Gasauslass 24 und einen Gasverteiler 20 auf. Der Gasverteiler 20 wird von zwei Zuleitungen 3, 4 mit den Prozessgasen versorgt und bei diesen Prozessgasen kann es sich um ein metallhaltiges erstes Gas (Precursor) und ein zweites reaktives Gas handeln. Die beiden Gase werden über die Zuleitung 3, 3' eines Gasverteilers 20 zugeleitet, der sich parallel und in einer horizontalen Ebene oberhalb des Suszeptors 22 befindet.

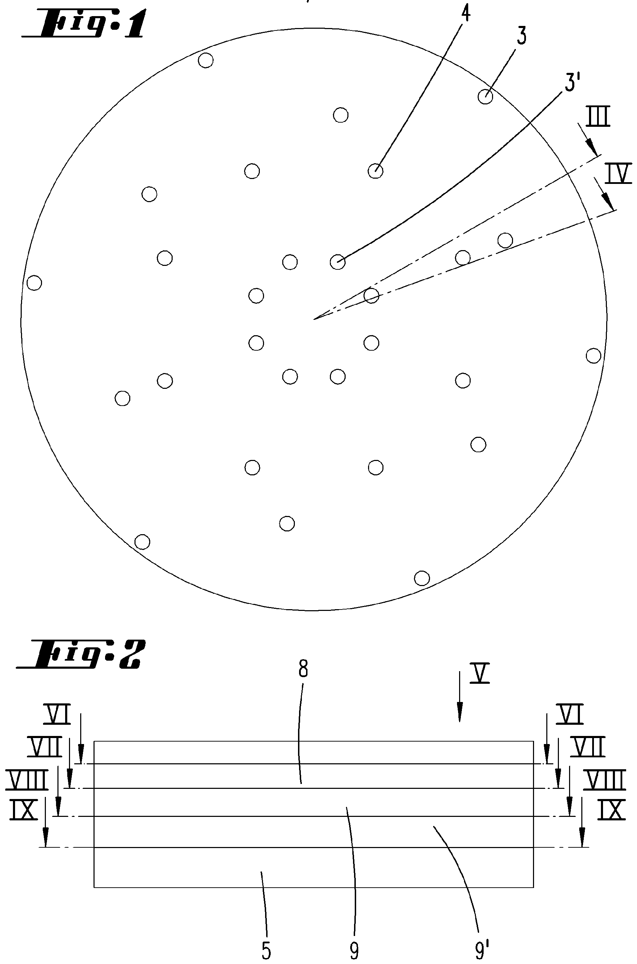

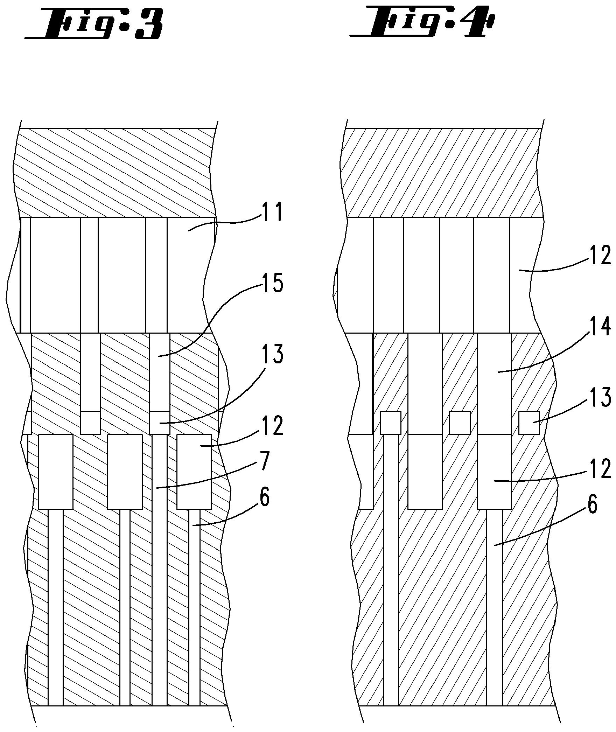

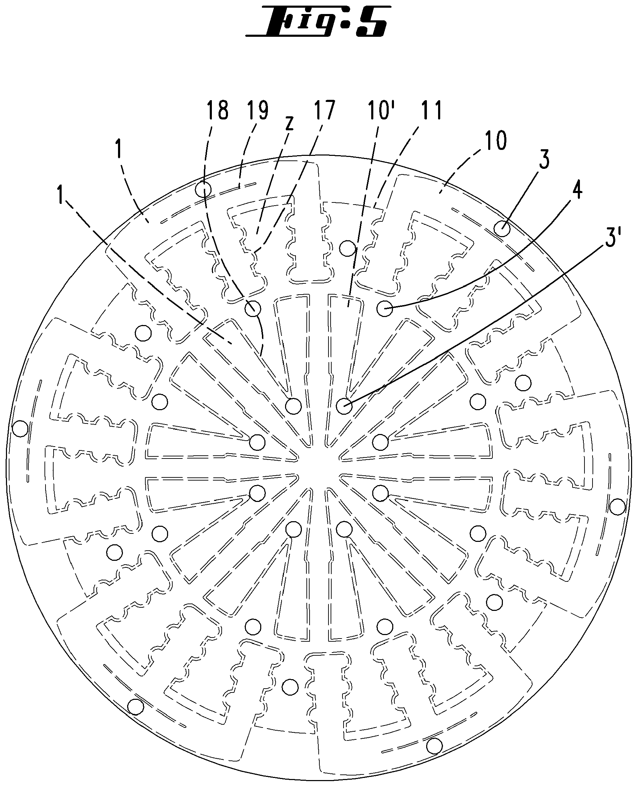

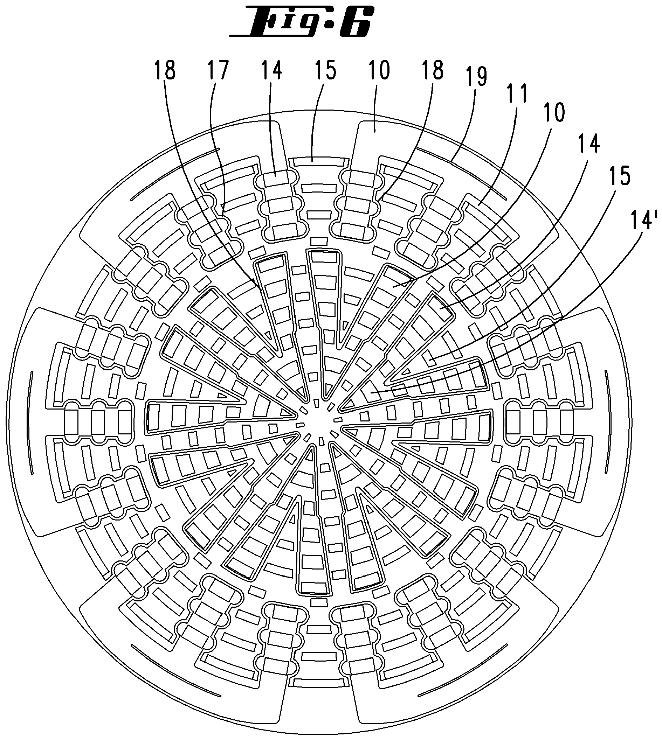

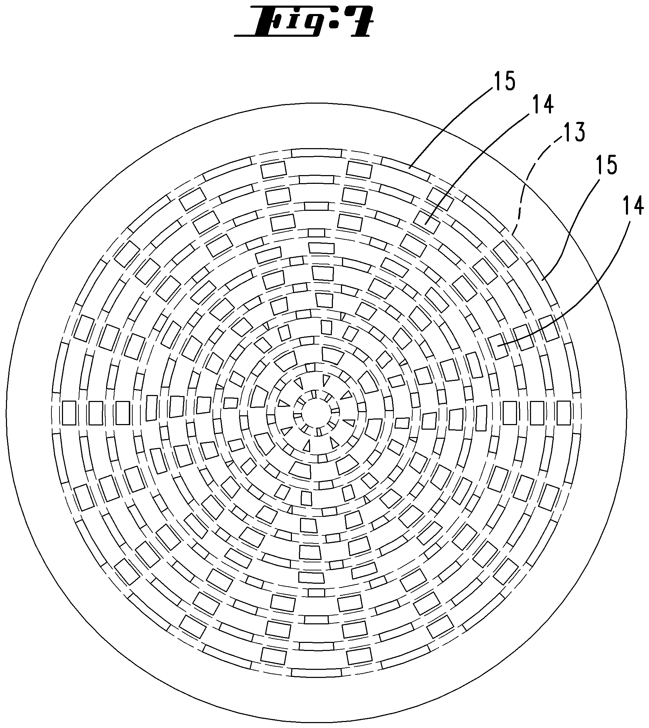

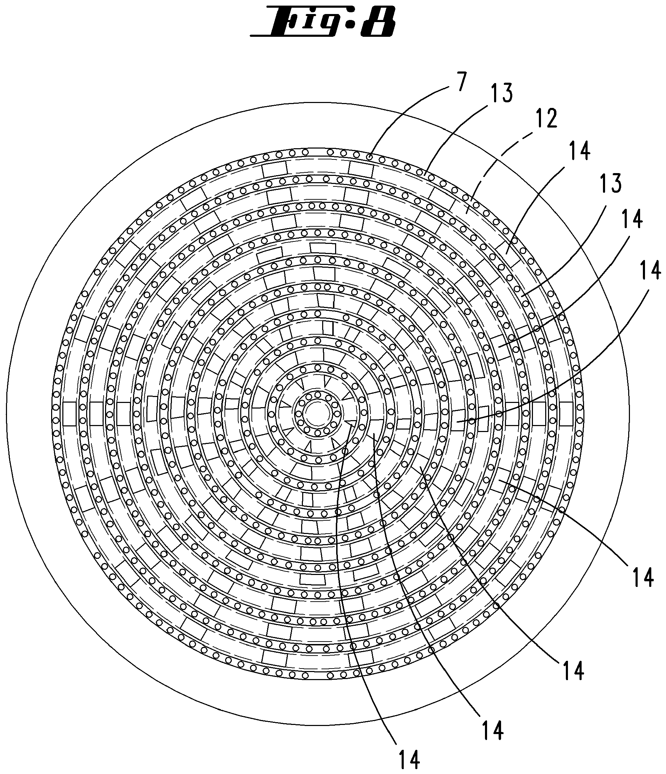

Die detaillierte Ausgestaltung des Gasverteilers 20 wird nachfolgend unter Bezugnahme auf die Figuren 1 bis 8 beschrieben.

Innerhalb des Gasverteilers 20 befinden sich zwei voneinander getrennte Gasvolumina 1, 2. In das Gasvolumen 1 wird über die Zuleitung 3, 3' das eine Metallkomponente beinhaltende erste Prozessgas eingeleitet. Es sind eine Vielzahl von verschiedenen Zuleitungen 3, 3' vorgesehen. In das zweite Gasvolumen 2 wird über eine Vielzahl von Zuleitungen 4 das zweite Prozessgas, bei dem es sich um ein reaktives Gas handelt, eingeleitet.

Wie insbesondere der Figur 1 zu entnehmen ist, beinhaltet das erste Gasvolumen eine Vielzahl von Vorkammern 10, die kammzinkenartig angeordnet sind, wobei sich die Kammzinken im Wesentlichen in Radialrichtung des eine Kreisgrundrissform aufweisenden Gasverteilers erstrecken. Zwischen diesen Kammzinken der Vorkammern 10 erstrecken sich Finger einer zweiten Vorkammer 11, die dem zweiten Gasvolumen zugeordnet ist. Die Finger der Vorkammer 11 sind von den Kammzinken der Vorkammer 10 durch eine Wand 17 getrennt.

In radialer Beabstandung zu den Vorkammern 10 sind Vorkammern 10' vorgesehen, die ebenfalls in Radialrichtung sich erstreckende Kammzinken ausbilden. Zwischen diesen Kammzinken der Vorkammer 10' befinden sich Abschnitte der Vorkammer 11. In die Vorkammer 10' wird dasselbe Prozessgas eingeleitet wie in die Vorkammer 10, so dass die Vorkammer 10, 10' einem Gasvolumen 1 zugehörig sind. Es ist aber auch möglich, in die Vorkammern 10, 10' unterschiedliche Prozessgase einzuleiten. Dies ist aber nicht bevorzugt.

Das Zentrum des Gasverteilers wird von der Vorkammer 11 ausgebildet, so dass die Vorkammern 10' im Querschnitt eine etwa V-förmige Grundrisskontur ausbilden. Die Vorkammern 10 bilden einen dreizinkigen Kamm aus, wobei die Zinken radial einwärts gerichtet sind. Die die einzelnen Abschnitte der Vorkammern 10, 10' voneinander trennenden Räume gehören der Vorkammer 11 an, die insgesamt einen sternförmigen Aufbau hat.

Wesentlich ist, dass die einzelnen Vorkammern 10, 10', 11 in Umfangsrichtung des Gasverteilers sich abwechseln, hierzu sind die Trennwände 17 vorgesehen, die die Vorkammern 10 und 11 voneinander trennen. Die Wände 18 trennen die Vorkammern 10', 11 voneinander. Im Bereich der Zuleitungsöffnung 3 besitzt die Vorkammer 10 noch ein Leitblech 19.

Der Gasverteiler besitzt einen aus mehreren Scheiben bestehenden Aufbau, wobei die Scheiben übereinander liegen. Die zuoberst liegende Scheibe bildet einen Deckel aus. Dieser deckt die Vorkammern 10, 10', 11 ab. Die Vorkammern 10, 10', 11 sind einer unterhalb des Deckels liegenden Scheibe zugeordnet. Sie sind in diese Scheibe beispielsweise durch Fräsen eingearbeitet.

Die Böden der Vorkammern 10, 10', 11, die in einer gemeinsamen Ebene liegen, besitzen nach unten ausgerichtete Öffnungen, die Verbindungskanäle 14,15 ausbilden. Diese Verbindungskanäle 14, 15 verbindet die Ebene 8 der Vorkammern 10, 10', 11 mit Ebenen 9, 9', in denen Gasverteilungskammern 12, 13 angeordnet sind.

Die Vorkammern 10, 10' sind mittels in Vertikalrichtung verlaufenden Verbindungskanälen 14 mit einer Vielzahl von das Zentrum des Gasverteilers umgebenden Gasverteilkammern 12 verbunden. Diese Gasverteilungskammern 12 sind ringförmige Kanäle, die in einer Ebene 9' angeordnet sind, die einer weiteren Scheibe zugeordnet sind. Die Ringstruktur der Gasverteilungskammern 12 kann durch Fräsen erzeugt werden.

Im Boden der ringförmigen das Zentrum umgebenden Gasverteilungskammern 12 befinden sich eine Vielzahl von Austrittsöffnungen 7. Diese werden von Bohrungen ausgebildet, die in der Bodenplatte 5 des Gasverteilers münden und durch welche das erste Prozessgas austreten kann.

Die im Boden der Vorkammer 11 angeordneten Verbindungskanäle 15 verbinden die Vorkammer 11 mit einer Vielzahl von ebenfalls konzentrisch das Zentrum des Gasverteilers umgebenden Gasverteilungskammern 13. Diese liegen in einer Ebene 9', die unterhalb der Ebene 9 angeordnet sind, so dass die Gasverteilkammern 12 und die Gasverteilungskammern 13 in verschiedenen Ebenen angeordnet sind.

Auch die Gasverteilkammern 13 besitzen bodenseitige Öffnungen, die Austrittsöffnungen 6 für das zweite Prozessgas ausbildet.

In Radialrichtung wechseln sich ringförmige Gasverteilungskammern 12 des ersten Prozessgases und ringförmig angeordnete Gasverteilungskammern 13 des zweiten Prozessgases miteinander ab.

Wie bereits erwähnt, kann der Gasverteiler aus einem geeigneten Metalls bestehen. Er besitzt vorzugsweise einen mehrschichtigen Aufbau. Der Gasverteiler kann temperiert sein und um den die Gasflusswege beinhaltenden Teil einen Rand mit thermischer Masse zur Temperaturhomogenisierung haben. Somit besitzt er entlang der Gasflusswege ein hohes Maß an Temperaturhomogenität.

Es wird als Wesentlich erachtet, dass in einer ersten Verteilebene eine radiale Verteilung des ersten Prozessgases und des zweiten Prozessgases erzielt wird und dass in einer weiteren Ebene eine Umfangsverteilung der beiden Prozessgase erzielt wird, wobei die Prozessgase getrennt voneinander aus den Austrittsöffnungen 6, 7 austreten. Die Umfangsverteilung der beiden Prozessgase kann darüber hinaus in zwei verschiedenen Ebenen stattfinden.

Es ist ferner vorteilhaft, dass die Gase den einzelnen Vorkammern 10, 10', 11 in einer Vielzahl von Zuleitungen 3, 3', 4 zugeleitet werden.

Neben der oben erwähnten MOCVD dient der Gasverteiler insbesondere der Verteilung von Gasen in einer Prozesskammer, in der ein Kondensationsverfahren zur Beschichtung von Substraten ausgeführt wird. Insbesondere werden bei den Prozessen oxidische Isolationsschichten (Dielektrika), Passivierungsschichten oder elektrisch leitende Schichten auf halbleitende, leitende oder isolierende Substrate abgeschieden.

Zur Durchführung des Verfahrens wird der Suszeptor 22 mittels einer rotierbaren Achse 23 gedreht. Die Prozesskammer 21 kann durch einen Flansch, der die Be- und Entladeöffnung 26 bildet, mit Substraten beladen werden die gasförmigen Precursoren und reaktiven Gase werden durch die separaten Zuleitungen 3 und 4 in den Gasverteiler 20 eingeleitet. Nicht verbrauchte Prozessgase werden durch den Gasauslass 24 abgepumpt. Der Gasverteiler 20 dient dem homogenen Gasaustritt der Prozessgase durch die Austrittsöffnungen 6, 7 an seiner Unterseite. Innerhalb der Prozesskammer 21 werden die Gase miteinander gemischt.

Für einen Arbeitsbereich von 300 bis 1200 sccm Gasfluss ergibt sich für die Verweilzeit der Gase im Gasverteiler 10ms bis 60ms. Für die gasförmigen Precursoren ergibt sich ein gesamter Druckabfall beim Durchfließen des Gasverteilers von < 2,5 mbar bei einem Gesamtfluss von 1,21 /min. Für viele Prozesse ist eine Temperaturinhomogenität entlang des Gasflussweges über den Durchmesser des Gasverteilers von weniger als 10% der Gasverteilertemperatur vorteilhaft. Für einen Gasfluss von 450sccm Argon als Trägergas für die gasförmigen Precursoren und 300sccm Sauerstoff als reaktives Gas ergeben sich bei einem Druck im Reaktorraum 21 von 2mbar folgende Ergebnisse: Beim Austritt der gasförmigen Precursoren aus den Austrittsöffnungen 6 des Gasverteilers 20 ergibt sich für die Flussverteilung eine Standardabweichung von 0,3% für die Kammer 10 und von 0,9% für die Kammer 10'. Für die reaktiven Gase der Kammer 11 ergibt sich beim Austritt aus den Austrittsöffnungen 7 des Gasverteilers eine Standardabweichung von 0,4%. Als inertes Trägergas kommen z. B. neben Stickstoff, Wasserstoff, Helium auch Argon in Betracht.

## Patentansprüche

1. Gasverteiler in einem CVD- oder OVPD-Reaktor mit zwei oder mehreren Gasvolumina (1, 2), in die jeweils eine Zuleitung (3, 4) für ein Prozessgas mündet, wobei jedes Gasvolumen (1, 2) mit einer Vielzahl von im Boden (5) des Gasverteilers mündende Austrittsöffnungen (6, 7) für das jeweilige Prozessgas verbunden ist, wobei die Prozessgase jeweils in einer ersten vom Boden (5) entfernt liegenden Ebene zunächst in Radialrichtung und in einer zweiten dem Boden (5) benachbarten Ebene dann in Umfangsrichtung verteilt werden, und durch Verbindungskanäle (14,15), die sich in einer zwischen erster und zweiter Ebene angeordneten dritten Ebene (16) befinden, strömen, wobei der zweiten Ebene (9) eine Vielzahl von jeweils einem Gasvolumen (1, 2) zugeordnete Gasverteilungskammern (12,13) vorgesehen sind, die mit den Austrittsöffnungen (6, 7) verbunden sind, **dadurch gekennzeichnet, dass** die Gasvolumina (1, 2) in einer gemeinsamen ersten Ebene (8) liegende Vorkammern (10, 10', 11) aufweisen, wobei die Vorkammern (10, 10', 11) zweier unterschiedlicher Gasvolumina (1, 2) kammartig ineinandergreifende kammzinkenartige, sich in Radialrichtung erstreckende Fortsätze ausbilden, wobei die in Umfangsrichtung nebeneinanderliegenden kammartigen Fortsätze von einer Wand (17) voneinander getrennt sind.

2. Gasverteiler nach Anspruch 1, **dadurch gekennzeichnet, dass** die zu einem Gasvolumen (1, 2) gehörenden Vorkammern (10, 10', 11) einen verschiedenen Radialabstand zum Zentrum des Gasverteilers haben.

3. Gasverteiler nach einem der vorhergehenden Ansprüche, **gekennzeichnet durch** verschiedene in Umfangsrichtung voneinander getrennt angeordnete Vorkammern (10) eines Gasvolumens.

4. Gasverteiler nach einem der vorhergehenden Ansprüche, **dadurch gekennzeichnet, dass** jede Vorkammer (10, 10', 11) von mehr als einer Zuleitung (3, 4) gespeist wird.

5. Gasverteiler nach einem der vorhergehenden Ansprüche, **dadurch gekennzeichnet, dass** ein erstes Gasvolumen (1) für die Zuführung eines gasförmigen, insbesondere metallhaltigen, bzw. halbleiterhaltigen Ausgangsstoffs und ein zweites Gasvolumen (2) für ein chemisch reaktives Gas vorgesehen ist, für insbesondere eine Sauerstoff-, Stickstoff- oder Wasserstoffverbindung.

6. Gasverteiler nach einem der vorhergehenden Ansprüche, **dadurch gekennzeichnet, dass** die Gasverteilungskammern (12,13) das Zentrum des Gasverteilers konzentrisch umgeben.

7. Gasverteiler nach einem der vorhergehenden Ansprüche, **dadurch gekennzeichnet, dass** eine Gasverteilungskammer (12,13) mit mehreren Vorkammern (10, 10', 11) mit Verbindungskanälen (14,15) verbunden ist oder dass eine Vorkammer (10, 10', 11) mit mehreren Gasverteilungskammern (12,13) mit Verbindungskanälen (14,15) verbunden ist.

8. Gasverteiler nach einem der vorhergehenden Ansprüche, **dadurch gekennzeichnet, dass** die Gasverteilkammern (12,13) in voneinander verschiedenen Teilebenen (9, 9') angeordnet sind.

9. Gasverteiler nach einem der vorhergehenden Ansprüche, **dadurch gekennzeichnet, dass** der Gasverteiler temperiert ist.

10. Gasverteiler nach einem der vorhergehenden Ansprüche, **dadurch gekennzeichnet, dass** der Gasverteiler aus massiv metallischen Teilen gefertigt ist, die eine thermische Masse ausbilden zur Temperaturhomogenisierung.

11. Gasverteiler nach einem der vorhergehenden Ansprüche, **dadurch gekennzeichnet, dass** der Gasverteiler aus mehreren aufeinander gesetzten Scheiben besteht, in welche die Vorkammern (10, 10', 11), die Gasverteilkammern (12,13), die Verbindungskanäle (14,15) und die Austrittsöffnungen (6, 7) eingearbeitet sind.

## Claims

1. Gas distributor in a CVD or OVPD reactor with two or more gas volumes (1, 2), into each of which a supply line (3, 4) for a process gas opens out, each gas volume (1, 2) being connected to a multiplicity of outlet openings (6, 7) for the respective process gas, which open out in the bottom (5) of the gas distributor, the process gases respectively being first distributed in a radial direction in a first plane, remote from the bottom (5), and then distributed in a circumferential direction in a second plane, adjacent the bottom (5), and flowing through connecting channels (14, 15), which are located in a third plane (16) disposed between the first plane and the second plane, a multiplicity of gas distributing chambers (12, 13) that are respectively associated with a gas volume (1, 2) and are connected to the outlet openings (6, 7) being provided in the second plane (9), **characterized in that** the gas volumes (1, 2) have pre-chambers (10, 10', 11) lying in a common first plane (8), the pre-chambers (10, 10', 11) of two different gas volumes (1, 2) forming continuations like prongs of a comb that extend in a radial direction and engage in one another in the manner of prongs of a comb, the comb-like continuations that lie next to one another in a circumferential direction being separated from one another by a wall (17).

2. Gas distributor according to Claim 1, **characterized in that** pre-chambers (10, 10', 11) that belong to one gas volume (1, 2) are at different radial distances from the center of the gas distributor.

3. Gas distributor according to one of the preceding claims, **characterized by** different pre-chambers (10) of a gas volume disposed separately from one another in a circumferential direction.

4. Gas distributor according to one of the preceding claims, **characterized in that** each pre-chamber (10, 10', 11) is fed by more than one supply line (3, 4).

5. Gas distributor according to one of the preceding claims, **characterized in that** a first gas volume (1) is provided for feeding a gaseous, in particular metal-containing or semiconductor-containing, starting material and a second gas volume (2) is provided for a chemically reactive gas, for in particular an oxygen, nitrogen or hydrogen compound.

6. Gas distributor according to one of the preceding claims, **characterized in that** the gas distributing chambers (12, 13) concentrically surround the center of the gas distributor.

7. Gas distributor according to one of the preceding claims, **characterized in that** a gas distributing chamber (12, 13) is connected to a number of pre-chambers (10, 10', 11) by connecting channels (14, 15) or **in that** a pre-chamber (10, 10', 11) is connected to a number of gas distributing chambers (12, 13) by connecting channels (14, 15).

8. Gas distributor according to one of the preceding claims, **characterized in that** the gas distributing chambers (12, 13) are disposed in partial planes (9, 9') that are different from one another.

9. Gas distributor according to one of the preceding claims, **characterized in that** the temperature of the gas distributor is controlled.

10. Gas distributor according to one of the preceding claims, **characterized in that** the gas distributor is produced from solid metal parts, which form a thermal mass for temperature homogenization.

11. Gas distributor according to one of the preceding claims, **characterized in that** the gas distributor comprises a number of disks placed on one another, into which the pre-chambers (10, 10', 11), the gas distributing chambers (12, 13), the connecting channels (14, 15) and the outlet openings (6, 7) are machined.

## Revendications

1. Distributeur de gaz dans un réacteur CVD ou OVPD avec deux ou plusieurs volumes de gaz (1, 2), une ligne d'alimentation (3, 4) respective pour un gaz de procédé débouchant dans chacun d'eux, chaque volume de gaz (1, 2) étant reliés à une pluralité d'ouvertures de sortie du distributeur de gaz (6, 7) débouchant dans le fond (5) du distributeur de gaz pour le gaz de procédé respectif, dans lequel les gaz de procédé sont d'abord distribués respectivement dans la direction radiale dans un premier niveau, éloigné du fond (5), et ensuite dans la direction circonférentielle dans un deuxième niveau voisin du fond (5), et les gaz s'écoulant à travers des canaux de liaison (14, 15) qui se situent dans un troisième niveau (16) disposé entre le premier niveau et le deuxième niveau, dans lequel une pluralité de chambres de distribution de gaz (12, 13) associées à un volume de gaz respectif est prévue dans le deuxième niveau, qui sont reliées aux ouvertures de sortie (6,7), **caractérisé en ce que** les volume de gaz (1, 2) comprennent des antichambres (10, 10',11) situées dans un premier niveau commun, dans lequel les antichambres (10, 10',11) de deux volumes de gaz différents (1, 2) forment des saillies s'étendant dans la direction radiale et qui sont en forme de dents de peigne qui s'interpénètrent à la façon de peignes, dans lequel les saillies en forme de peigne agencées les unes à côté des autres dans la direction circonférentielle sont séparées les unes des autres par une paroi (17)

2. Distributeur de gaz selon la revendication 1, **caractérisé en ce que** les antichambres (10, 10',11) appartenant à un volume de gaz (1, 2) ont une distance radiale différente par rapport au centre du distributeur de gaz.

3. Distributeur de gaz selon l'une quelconque des revendications précédentes, **caractérisé par** différentes antichambres (10) d'un volume de gaz agencées séparées les unes des autres dans la direction circonférentielle.

4. Distributeur de gaz selon l'une quelconque des revendications précédentes, **caractérisé en ce que** chaque antichambre (10, 10', 11) est alimentée par plus d'une ligne d'alimentation (3, 4).

5. Distributeur de gaz selon l'une quelconque des revendications précédentes, **caractérisé en ce que** sont prévus un premier volume de gaz (1) pour l'introduction d'une substance gazeuse de départ, en particulier contenant un métal ou un semiconducteur, et un deuxième volume de gaz (2) pour un gaz chimiquement réactif, en particulier pour un composé d'oxygène, d'azote ou d'hydrogène.

6. Distributeur de gaz selon l'une quelconque des revendications précédentes, **caractérisé en ce que** les chambres de distribution de gaz (12, 13) entourent de manière concentrique le centre du distributeur de gaz.

7. Distributeur de gaz selon l'une quelconque des revendications précédentes, **caractérisé en ce qu'**une chambre de distribution de gaz (12, 13) est reliée à plusieurs antichambres (10, 10', 11) par des canaux de liaison (14, 15) ou **en ce qu'**une antichambre (10, 10', 11) est reliée à plusieurs chambres de distribution de gaz (12, 13) par des canaux de liaison (14, 15).

8. Distributeur de gaz selon l'une quelconque des revendications précédentes, **caractérisé en ce que** les chambres de distribution de gaz (12, 13) sont disposées dans des niveaux partiels (9, 9') mutuellement différents.

9. Distributeur de gaz selon l'une quelconque des revendications précédentes, **caractérisé en ce que** le distributeur de gaz est tempéré.

10. Distributeur de gaz selon l'une quelconque des revendications précédentes, **caractérisé en ce que** le distributeur de gaz est composé de parties métalliques massives qui forment une masse thermique pour l'homogénéisation de la température.

11. Distributeur de gaz selon l'une quelconque des revendications précédentes, **caractérisé en ce que** le distributeur de gaz est constitué de plusieurs disques empilés dans lesquels les antichambres (10, 10', 11), les chambres de distribution de gaz (12, 13), les canaux de liaison (14, 15) et les ouvertures de sortie (6, 7) sont intégrés.
